(19) Europäisches Patentamt
European Patent Office
Office européen des brevets

(11) EP 2 743 719 A1

(12) EUROPÄISCHE PATENTANMELDUNG

(43) Veröffentlichungstag:
18.06.2014 Patentblatt 2014/25

(51) Int Cl.:
*G01R 35/00* (2006.01)

(21) Anmeldenummer: 13005631.0

(22) Anmeldetag: 04.12.2013

(84) Benannte Vertragsstaaten:
AL AT BE BG CH CY CZ DE DK EE ES FI FR GB
GR HR HU IE IS IT LI LT LU LV MC MK MT NL NO
PL PT RO RS SE SI SK SM TR
Benannte Erstreckungsstaaten:
BA ME

(30) Priorität: 14.12.2012 DE 102012024480

(71) Anmelder: EADS Deutschland GmbH
85521 Ottobrunn (DE)

(72) Erfinder:
• Höfer, Georg
89173 Lonsee (DE)
• Erbert, Marcel
89231 Neu-Ulm (DE)

(74) Vertreter: Meel, Thomas
EADS Deutschland GmbH
Patentabteilung, CXLIG
88039 Friedrichshafen (DE)

(54) **Verfahren zur Kalibrierung von Messdaten aus Hochfrequenzmessungen an einer automatisierten Prüfeinrichtung**

(57) Die Erfindung betrifft ein Verfahren zur Kalibrierung von Messdaten aus Hochfrequenzmessungen an einer automatisierten Prüfeinrichtung (100) zur Vermessung einer Mehrzahl von Mikrowellenbauelementen (52), welche von Prüfköpfen (10,30) der Prüfeinrichtung an definierten Kontaktpositionen kontaktiert werden. Gemäß der Erfindung werden die durch Positionsänderungen der Prüfköpfe (10,30) verursachten Störgrößen an jeder Kontaktposition durch eine auf eine ortsfeste Referenzkalibrierung bezogene Kalibriermessung an einem Reflexionsstandard erfasst und die so erfassten Störgrößen über ein Deembedding-Verfahren kompensiert.

Fig. 1

**Beschreibung**

Die Erfindung betrifft ein Verfahren zur Kalibrierung von Messdaten aus Hochfrequenzmessungen an einer automatisierten Prüfeinrichtung zur Vermessung einer Mehrzahl von Mikrowellenbauelementen nach dem Oberbegriff des Anspruchs 1.

Der Einsatz der Automatisierungstechnik in Prüfeinrichtungen zur Hochfrequenz-Charakterisierung von Baugruppen oder Schaltungen kann es erforderlich machen, die Prüfadapter, welche über Kabel mit den Prüfgeräten verbunden werden, zur Kontaktierung der Schnittstellen einer oder mehrerer Baugruppen oder Schaltungen neu zu positionieren. Die HF-Eigenschaften der Prüfadapter werden über geeignete Deembedding-Verfahren berücksichtigt [1]. Für die Positionierung werden z.B. Linearachsen oder Roboter und Schleppketten für Kabel als Hilfsmittel eingesetzt.

Durch die Positionsänderung der Adapter sowie der zugehörigen Prüfköpfe, auf der ein solcher Adapter angeordnet ist, können durch die hierzu notwendige Kabelbewegung Änderungen der HF-Eigenschaften des Prüfaufbaus (sog. "systematische Fehler") verursacht werden, insbesondere wenn die Positionsänderung über längere Strecken, z.B. mit Hilfe einer Schleppkette, erfolgt. Diese systematischen Fehler äußern sich als Phasen- und Amplitudenverschiebung, welche sich den Messwerten additiv überlagert und die Genauigkeit von Messungen beeinträchtigt. Zusätzlich wirken sich beim Einsatz langer Messkabel Temperaturänderungen in der Umgebung verstärkt aus und führen ebenfalls zu derartigen Fehlern.

In der US 6,249,128 B1 ist ein rekursives Verfahren zur Kalibrierung eines Hochfrequenzprüfsystems, mit dem das Reflexionsverhalten des individuellen Prüflings bestimmt werden kann, bekannt. Auf Basis des Reflexionsverhaltens wird ein Korrekturfaktor für den Pegel des Testsignals bestimmt. Der verwendete Prüfkopf enthält umschaltbare Kalibrierelemente OPEN-SHORT-LOAD. Diese Kalibrierelemente sind über eine Schalteinheit und zusätzliche Leitungen verbunden, welche naturgemäß Amplituden- und Phasenoffsets verursachen. Dieses zwischen Kalibrierebene und umschaltbaren Kalibrierelementen eingefügte Verteilnetzwerk wird über ein Deembedding-Verfahren beseitigt.

Der Erfindung liegt die Aufgabe zugrunde, ein geeignetes Kalibrierverfahren anzugeben, so dass auch bei automatisierten Prüfsystemen mit bewegten Prüfköpfen eine hohe Genauigkeit bei den durchzuführenden Hochfrequenzmessungen erreicht werden kann.

Diese Aufgabe wird mit dem Verfahren nach Patentanspruch 1 gelöst. Vorteilhafte Ausführungen sind Gegenstand von weiteren Ansprüchen.

Gemäß der Erfindung werden die durch die Bewegung der Prüfköpfe verursachten Änderungen der HF-Eigenschaften des Prüfaufbaus hinsichtlich Amplitude und Phase als Störgrößen positionsabhängig und vorteilhaft auch zeitabhängig ermittelt und können danach durch Deembedding-Verfahren kompensiert werden können.

Durch das erfindungsgemäße Verfahren der positionsabhängigen Störgrößenermittlung können darüber hinaus auch andere Störeinflüsse, insbesondere durch Temperaturschwankungen verursachte, erfasst und korrigiert werden.

Phasen- und Amplitudenfehler, welche auf Kabelbewegungen zurückzuführen sind, werden an der Messposition erfasst und korrigiert.

Phasen- und Amplitudenfehler, welche auf Temperaturänderungen von z.B. Messkabeln zurückzuführen sind, können zum Messzeitpunkt erfasst und korrigiert werden.

Durch den erfindungsgemäßen Ansatz, die dynamischen Eigenschaften des Prüfaufbaus zu betrachten, kann die Systemgenauigkeit eines automatisierten Hochfrequenz-Prüfaufbaus auf einem sehr hohen Niveau gehalten werden.

Die Erfindung wird anhand konkreter Ausführungsbeispiele unter Verweis auf die folgenden Figuren näher erläutert. Es zeigen:

Fig. 1: den Prüfaufbau einer automatisierten Prüfeinrichtung mit mehreren Prüflingen zum Durchführung des erfindungsgemäßen Verfahrens (Draufsicht);

Fig. 2: einen beweglichen Prüfkopf als Teil der Prüfeinrichtung gemäß Fig. 1;

Fig. 3: den Prüfkopf nach Fig. 2 in einer detaillierten Darstellung;

Fig. 4: ein HF-Modell des Prüfaufbaus einschließlich modellierter Störgrößen und zugehörigen Kalibrierebenen;

Fig. 5: eine schematische Darstellung der Messwerte und Störgrößen bei der Durchführung der einzelnen Kalibriermessungen, getrennt für die beiden Prüfschnittstellen der Prüfeinrichtung;

Fig. 6: eine Übersicht über die rechnerische Beschreibung des angewandten Deembedding-Verfahrens.

Das erfindungsgemäße Verfahren wird im Folgenden anhand einer Prüfeinrichtung beschrieben, die beispielhaft genau zwei Prüfschnittstellen zu einem zu vermessenden Mikrowellenbauelement aufweist. Es wird jedoch darauf hingewiesen, dass das erfindungsgemäße Verfahren für Prüfeinrichtungen mit einer beliebigen Anzahl von Prüfschnittstellen geeignet ist.

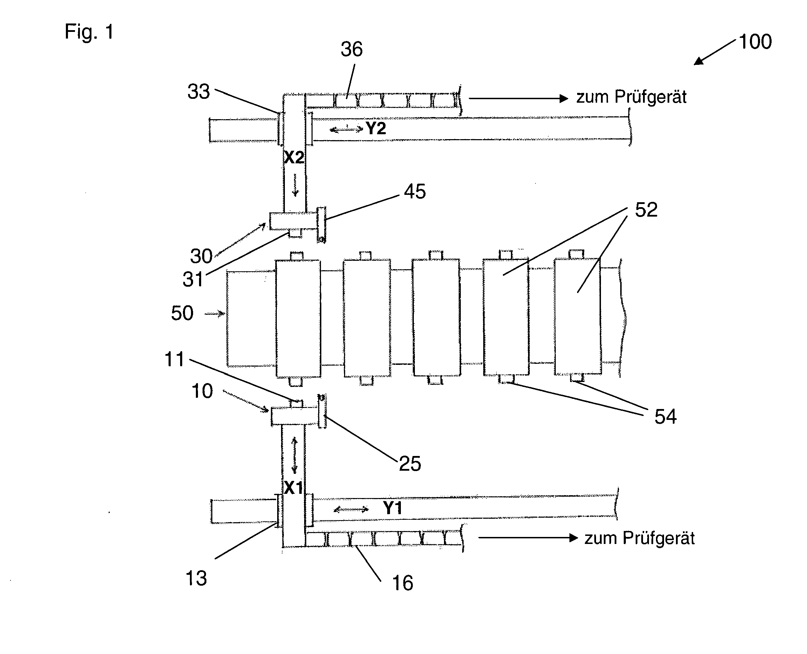

Fig. 1 zeigt den Prüfaufbau einer Prüfeinrichtung 100, welche auf einer horizontal angeordneten Beladungsfläche der Trägerplatte 50 beidseitig mehrere Prüflinge 52 kontaktiert. Die Prüflinge 50 weisen dazu jeweils zwei Prüfschnittstellen (HF-Anschlüsse 54) auf. Die Kontaktierung mit dem Prüfgerät (nicht dargestellt, typischerweise ein Netzwerkanalysator) der Prüfeinrichtung erfolgt an Prüfadaptern 11, 31 welche auf zwei beweglichen Prüfköpfen 10,30 montiert sind. Die Prüfköpfe 10,30 werden jeweils von einer zwei-dimensionalen (X/Y)-Verfahreinheit transportiert, welche aus jeweils zwei rechtwinklig angeordneten Linearachsen X1,Y1 bzw. X2,Y2 sowie einem Verfahrschlitten 13,33 zusammengesetzt ist.

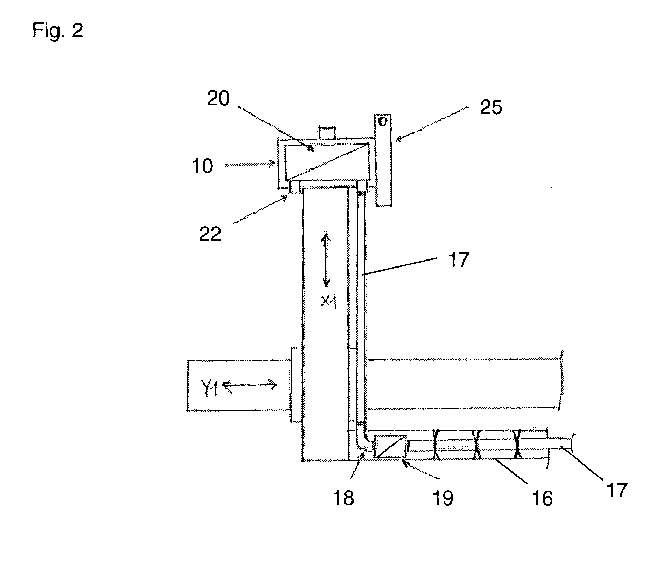

Wie man am besten aus der Fig. 2 erkennt, ist auf dem Verfahrschlitten 13,33 der langen Achsen Y1,Y2 jeweils eine Schleppkette 16,36 angebracht, in der geeignete HF-Kabel 17 zugeführt werden, welche das Prüfgerät mit den Prüfadaptern 11,31 auf den Prüfköpfen 10,30 verbinden. Die Übertragungsstrecke vom Verfahrschlitten 13,33 der langen Achsen Y1,Y2 zum Prüfkopf 10,30 auf den kurzen Achsen X1, X1 wurde über ein 90°-Winkelstück 18 realisiert, welches über eine Drehkupplung 19 mit dem HF-Kabelstück 17 in der Schleppkette 16,36 verbunden ist. Die Drehkupplung 19 dient zum Ausgleich der Torsionsspannung zwischen den rechtwinklig verbundenen HF-Kabelstücken 17, welche bei Bewegung der kurzen Achse X1,X2 entstehen kann.

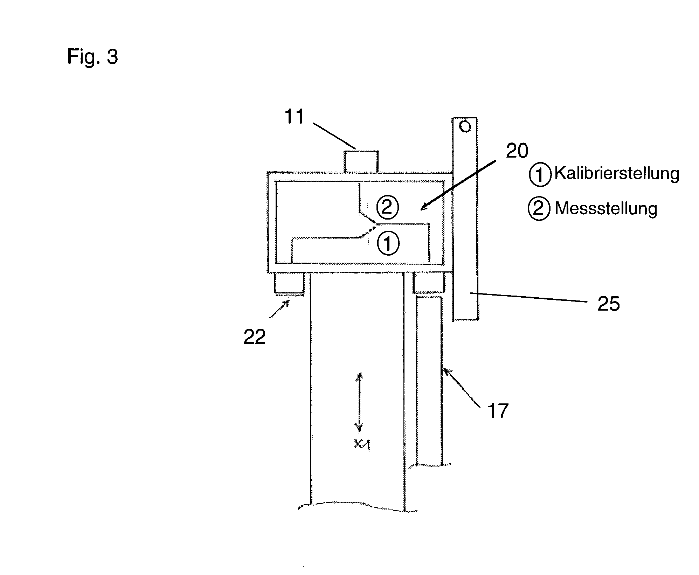

Auf einem Prüfkopf 10,30 ist jeweils ein Umschaltrelais 20 vorhanden, welches entweder den Prüfling 52 über den Prüfadapter 11,31 oder einen ebenfalls auf dem Prüfkopf 10,30 vorhandenen HF-Kurzschluss 22 mit dem Prüfgerät verbindet (Fig. 3). Jeder Prüfkopf 10,30 realisiert eine Prüfschnittstelle der Prüfeinrichtung 100.

Der HF-Kurzschluss 22 auf dem Prüfkopf 10,30 wird als Reflexionsstandard für Kalibrier-Messungen verwendet. Auf diesen Reflexionsstandard werden im Folgenden als Trackingmessungen bezeichnete Kalibriermessungen durchgeführt. Trackingmessungen werden an der jeweiligen Kontaktposition des Prüfkopfs 10,30 bzw. zugehörigen Prüfadapters 11,31 mit einem Prüfling 52 durchgeführt. In zeitlicher Hinsicht erfolgt eine Trackingmessung bevorzugt unmittelbar vor der Vermessung des Prüflings.

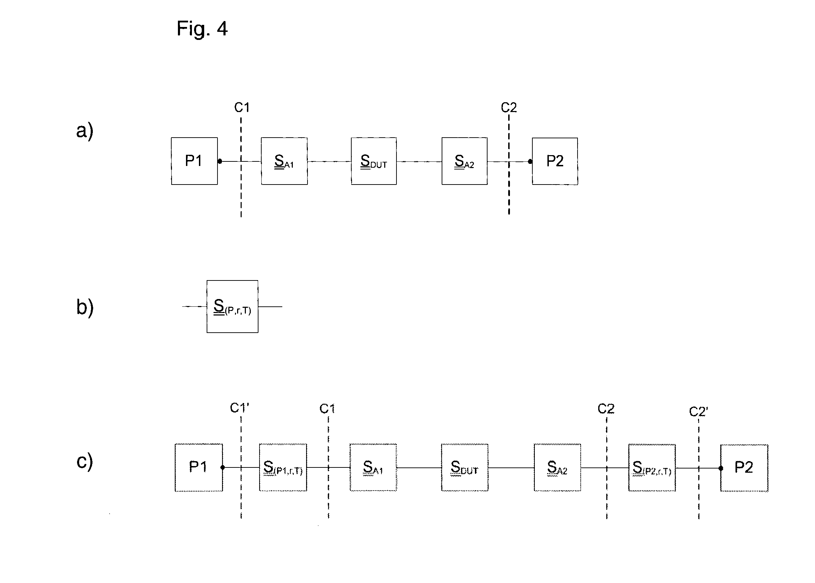

Aus den Trackingmessungen werden somit die dynamischen Eigenschaften des Prüfaufbaus positionsabhängig und auch temperaturabhängig zum Messzeitpunkt ermittelt und einem fiktiven Netzwerk-Element (siehe Fig. 4b) in Form einer komplexen Streumatrix $\underline{S}_{(P,r,T)}$ zugeordnet (Größen, welche Matrizen symbolisieren, werden hier und im Folgenden zweifach unterstrichen dargestellt). Dabei bezeichnet $r$ den Ortsvektor und $T$ die Umgebungstemperatur. Dieses Verfahren wird im Folgenden als dynamisches Deembedding bezeichnet. Das zugehörige HF-Modell vor und nach Einführung des fiktiven Netzwerk-Elements ist in Fig. 4a bzw. Fig. 4c schematisch dargestellt. Im Zentrum befindet sich der Prüfling $\underline{S}_{DUT}$ mit den Prüfadaptern $\underline{S}_{A1}$ und $\underline{S}_{A2}$. Fehler, die z.B. durch Positions- oder Temperaturänderungen entstehen, werden als fiktive Störmatrizen $\underline{S}_{(P1,r,T)}$ und $\underline{S}_{(P2,r,T)}$ für jede der beiden Prüfschnittstellen modelliert. P1 und P2 stellen die Anschlüsse des Prüfgerätes mit Verbindungselementen vom Prüfgerät bis zu den Kalibrierebenen C1 und C2 dar. Die systematischen Fehler, die in den benannten fiktiven Netzwerkelementen enthalten sind, führen zu einer Verschiebung der Kalibrierebenen von C1 nach C1' bzw. C2 nach C2'.

Die Erfassung der genannten systematischen Fehler sowie deren Korrektur erfolgt automatisch an jeder Kontaktposition.

Die Trackingmessungen sind bezogen auf eine sogenannte Referenzmessung, d.h. eine Kalibriermessung ebenfalls auf den HF-Kurzschluss (Reflexionsstandard). Eine Referenzmessung wird (pro Prüfschnittstelle der Prüfeinrichtung) jedoch nur einmal durchgeführt, wobei deren Ort grundsätzlich beliebig gewählt werden kann.

An dem Ort der Referenzmessung erfolgt - bevorzugt zeitnah - die (einmalige) Grundkalibrierung des Prüfgeräts. Bei der Grundkalibrierung handelt es sich z.B. um eine 12-Term S-Parameter Kalibrierung, wobei auch beliebige andere Kalibriermethoden möglich sind. Die Möglichkeit einer solchen Grundkalibrierung ist üblicherweise bereits im Prüfgerät standardmäßig implementiert.

Um das dynamische Deembedding bedarfsgerecht anzuwenden, wird die Lage der Kontaktposition beim Kontakt mit dem Prüfling vorteilhaft mit erhöhter Genauigkeit ermittelt. Hierzu werden in dem in den Fig. 1 bis 3 gezeigten Ausführungsbeispiel mit Hilfe von Gabellichtschranken 25,45, die auf den Messköpfen integriert und entlang der kürzeren Achse X1,X2 ausgerichtet sind (Fig. 3), die Positionsdaten der Anschlussstellen 54 aller Prüflinge 52 zweimalig in gegensätzlichen Richtungen abgetastet. Diese Vorgehensweise kompensiert die Schalthysterese der Lichtschranke. Diese Abtastung wird im folgenden Scan-Fahrt genannt. Während der Scan-Fahrt ist der Prüfadapter nicht mit dem Prüfling verbunden.

Die Scan-Fahrt liefert neben den genauen Kontaktpositionen (Positionsdaten der Anschlüsse der einzelnen Prüflinge) auch Informationen über die Beladung (Anzahl der Prüflinge) der Prüfeinrichtung.

Nach der Ermittlung der Kontaktpositionen wird die eigentliche Messfahrt zur Vermessung der Prüflinge durchgeführt. Da die genauen Positionsdaten der Anschlüsse der Prüflinge nunmehr bekannt sind, kann der Prüfkopf mit dem betreffenden Prüfadapter auf die jeweilige Kontaktposition (Messposition) gefahren werden. An jeder Kontaktposition wird zunächst eine Trackingmessung mit dem HF-Kurzschluss (Reflexionsstandard) durchgeführt, um eine relative Änderung zur Referenzmessung zu ermitteln. Danach wird das am Prüfkopf vorhandene Umschaltrelais betätigt, um das Prüfgerät mit dem Prüfling zu verbinden und es findet an den momentanen Kontaktpositionen die Vermessung des Prüflings statt. Vorteilhaft erfolgt die Vermessung eines Prüflings unmittelbar nach Beendigung einer Trackingmessung ohne weitere Verzögerung. Danach fährt der Prüfkopf weiter zur nächsten Kontaktposition und die beschriebenen Arbeitsgänge Trackingmessung/Vermessung des Prüflings wiederholen sich.

Die Differenz von Betrag und Phase einer Trackingmessung zur Referenzmessung dient zur Ermitt-

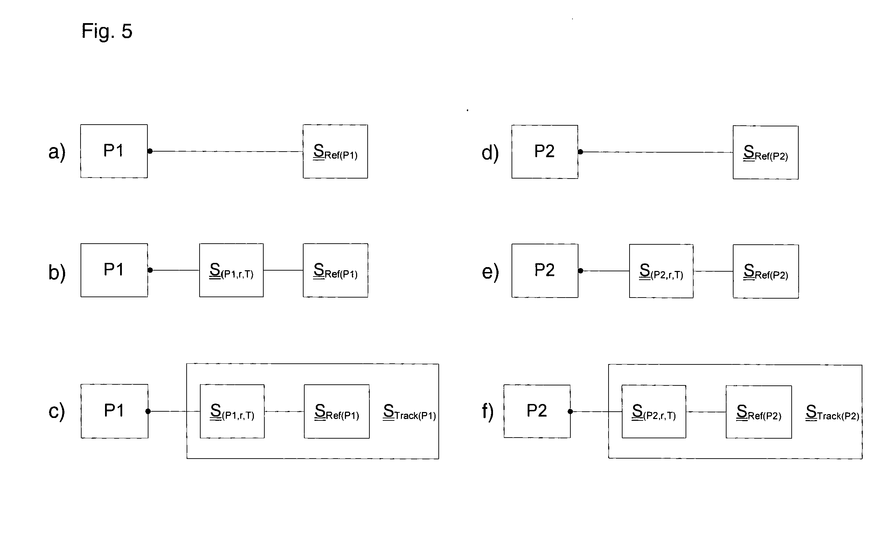

lung der Korrekturmatrizen $\underline{\underline{S}}^{-1}_{(P1,r,T)}$ für die Prüfschnittstelle P1 des Prüfgeräts und $\underline{\underline{S}}^{-1}_{(P2,r,T)}$ für die Prüfschnittstelle P2, wie in Fig. 5 a - c für Prüfschnittstelle P1 und in Fig. 5 d - f die Prüfschnittstelle P2 im Einzelnen dargestellt. Dabei bezeichnet S eine komplexe Streumatrix, r den Ortsvektor und T die Umgebungstemperatur.

Mit positionsabhängigen, mittels der beschriebenen Kalibriermessungen ermittelten, Korrekturmatrizen wird nun an jeder Kontaktposition über eine Deembedding-Rechnung aus der Grundkalibrierung ein neuer Kalibrierdatensatz erzeugt, der die Kalibrierebenen C1' und C2', wieder in den Zustand der Grundkalibrierung C1 und C2 transformiert (siehe hierzu Fig. 4c). Dieser neue, von der Grundkalibrierung abgeleitete 12-Term Kalibrierdatensatz enthält alle systematischen Abweichungen im Prüfaufbau, welche seit der Grundkalibrierung aufgetreten sind. Die Störeinflüsse durch systematische Fehler werden beseitigt und die Qualität der Grundkalibrierung in Bezug auf die Adapter-Schnittstellen wieder hergestellt.

Im Folgenden werden beispielhaft die Bestimmung der Störgrößen und das Korrekturverfahren im Detail beschrieben.

Schlägt man die beschriebenen Störeinflüsse nach Betrag und Phase, welche aus einer Reflexionsmessung zu bestimmen sind, einem hypothetischen verlustbehafteten aber anpassten Leitungsstück zu ("fiktives Netzwerkelement"), dann kann dieses wie folgt bestimmt werden:

Schritt-1: Aufnahme der Referenzmessungen $\underline{S}_{Ref(P1)}$ für Prüfschnittstelle P1 und $\underline{S}_{Ref(P2)}$ für Prüfschnittstelle P2 unmittelbar nach der Systemkalibrierung (Grundkalibrierung), wie in Fig 5a bzw. Fig. 5d schematisch dargestellt.

Schritt-2: Während des Betriebes entstehen im Leitungszug Störungen, welche durch eine fiktive Störmatrix $\underline{S}_{(P1,r,T)}$ für Prüfschnittstelle P1 und $\underline{S}_{(P2,r,T)}$ für Prüfschnittstelle P2 modelliert werden. Sie sind in Fig. 5b bzw. Fig. 5e dargestellt.

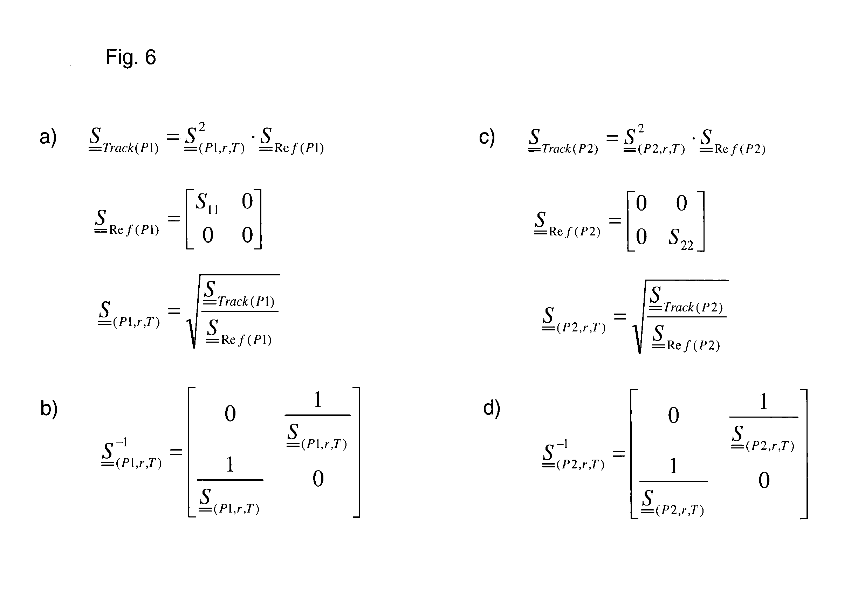

Schritt-3: Zur Bestimmung der Störmatrizen werden wie beschrieben Tracking messungen $\underline{S}_{Track(P1)}$ und $\underline{S}_{Track(P2)}$ auf die Reflexionsstandards durchgeführt, wie in Fig. 5c bzw. Fig. 5f dargestellt. Schritt-4: Aus den Trackingmessungen $\underline{S}_{(P1,r,T)}$ und $\underline{S}_{(P2,r,T)}$ werden die Störmatrizen $\underline{S}_{(P1,r,T)}$ und $\underline{S}_{(P2,r,T)}$ berechnet. Die Wellen durchlaufen die Störmatrizen bei der Trackingmessung auf dem Hin- und Rückweg, also doppelt. Die entsprechende Berechnungsvorschrift für die Störmatrizen kann Fig. 6a für Prüfschnittstelle P1 bzw. Fig. 6c für Prüfschnittstelle P2 entnommen werden.

Schritt-5: Zur Korrektur ist das Antinetzwerk der Störmatrizen zu berechnen. Das Antinetzwerk verhält sich zur Störmatrix invers und korrigiert die Störgrößen. Da die Störmatrix definitionsgemäß reflexionsfrei und angepasst ist, ergibt sich für die Korrekturmatrizen $\underline{S}^{-1}_{(P1,r,T)}$ und $\underline{S}^{-1}_{(P2,r,T)}$ eine Berechnungsvorschrift [2] gemäß Fig. 6b bzw. Fig. 6d.

Schritt-6: Der Datensatz der Grundkalibrierung kann nunmehr mit den so berechneten Korrekturmatrizen für die einzelnen Prüfschnittstellen P1 und P2 modifiziert werden.

Begriffserklärungen:

Dynamisches Deembedding:

Deembedding-Verfahren, bei dem die Deembedding-Datensätze orts- und zeitabhängig, und zwar an der Kontaktposition (Messposition zur Vermessung der Prüflinge) und bevorzugt unmittelbar vor Durchführung der Messung des jeweiligen Prüflings, ermittelt werden.

Systematische Fehler:

Verzerrungsfehler, die sich nicht im Mittel aufheben. Systematische Fehler äußern sich in einer Ablage oder "Offset".

Prüfschnittstelle:

Prüfgeräteanschluss mit Zuleitungskomponenten bis zur Kalibrierebene.

Grundkalibrierung:

S-Parameter-Kalibrierung des Prüfgeräts mit definierten Standards, z.B. nach dem SOLT-Verfahren, bevorzugt am Ort der Referenzmessung.

Referenzmessung:

Bestimmung der Eigenschaften der Prüfschnittstellen durch eine Kalibriermessung auf den Reflexionsstandard an einer beliebigen, aber definierten Position des Prüfaufbaus, durchgeführt bevorzugt unmittelbar nach der Grundkalibrierung.

Trackingmessung:

Kalibriermessung auf den Reflexionsstandard, und zwar an der jeweiligen Kontaktposition des Prüfkopfs mit dem zu vermessenden Prüfling.

Fiktives Netzwerkelement:

Dient zur modellhaften Beschreibung der Summe aller Störungen im Leitungszug.

**In der Beschreibung genannter Stand der Technik:**

[1] Product Note 8510-13: "Measuring Non-insertable Devices", Agilent Technologies, Doc.-No. 5956-4373, Aug.-1988;
[2] Application Note 1364-1 "De-embedding and Embedding S-Parameter Networks Using a Vector Network Analyzer", Agilent Technologies, Doc.-No. 5980-2784EN, May-30, 2004.

**Patentansprüche**

1. Verfahren zur Kalibrierung von Messdaten aus Hochfrequenzmessungen an einer automatisierten Prüfeinrichtung (100) zur Vermessung einer Mehrzahl von Mikrowellenbauelementen (52), welche von Prüfköpfen (10,30) der Prüfeinrichtung an definierten Kontaktpositionen kontaktiert werden, **dadurch gekennzeichnet, dass** durch Positionsänderungen der Prüfköpfe (10,30) verursachte Störgrößen an jeder Kontaktposition durch eine auf eine ortsfeste Referenzmessung bezogene Kalibriermessung an einem Reflexionsstandard erfasst werden und die so erfassten Störgrößen über ein Deembedding-Verfahren kompensiert werden.

2. Verfahren nach Anspruch 1, **dadurch gekennzeichnet, dass** die Kontaktpositionen mit Hilfe optischer Messungen, z.B. Laser-Abstandsmessungen oder Lichtschranke (25), ermittelt werden und damit eine exakte Ausrichtung der Prüfköpfe (10,30) für die Kontaktierung der zu prüfenden Mikrowellenbauelemente (52) ermittelt wird.

3. Verfahren nach Anspruch 1 oder 2, **dadurch gekennzeichnet, dass** die Kalibriermessung nach einer automatisierten Umschaltung auf einen HF-Kurzschluss (22) am Prüfkopf durchgeführt wird.

4. Verfahren nach einem der vorangehenden Ansprüche, **dadurch gekennzeichnet, dass** an dem Ort der Referenzmessung eine einmalige Grundkalibrierung der Prüfeinrichtung durchgeführt wird.

5. Verfahren nach Anspruch 4, **dadurch gekennzeichnet, dass** die Referenzmessung zeitnah zu der Grundkalibrierung durchgeführt wird.

6. Verfahren nach Anspruch 4 oder 5, **dadurch gekennzeichnet, dass** die Grundkalibrierung eine S-Parameter-Kalibrierung ist.

7. Verfahren nach einem der vorangehenden Ansprüche, **dadurch gekennzeichnet, dass** die an den Kontaktpositionen durchzuführenden Kalibriermessungen jeweils zeitnah durchgeführt werden mit der Vermessung der an den entsprechenden Kontaktpositionen kontaktierten Mikrowellenbauelemente.

8. Verfahren nach einem der vorangehenden Ansprüche, **dadurch gekennzeichnet, dass** es für Prüfeinrichtungen mit beliebiger Anzahl von Prüfköpfen anwendbar ist.

Fig. 1

zum Prüfgerät

zum Prüfgerät

EP 2 743 719 A1

Fig. 2

EP 2 743 719 A1

EP 2 743 719 A1

Fig. 3

11

20

① Kalibrierstellung

② Messstellung

②

①

22

25

17

x₁

Fig. 4

Fig. 5

a)  P1 —•—————— $\underline{S}_{Ref(P1)}$

b)  P1 —•—— $\underline{S}_{(P1,r,T)}$ —— $\underline{S}_{Ref(P1)}$

c)  P1 —•—— $\underline{S}_{(P1,r,T)}$ —— $\underline{S}_{Ref(P1)}$   $\underline{S}_{Track(P1)}$

d)  P2 —•—————— $\underline{S}_{Ref(P2)}$

e)  P2 —•—— $\underline{S}_{(P2,r,T)}$ —— $\underline{S}_{Ref(P2)}$

f)  P2 —•—— $\underline{S}_{(P2,r,T)}$ —— $\underline{S}_{Ref(P2)}$   $\underline{S}_{Track(P2)}$

EP 2 743 719 A1

Fig. 6

a) $$\underline{\underline{S}}_{Track(P1)} = \underline{\underline{S}}_{(P1,r,T)}^2 \cdot \underline{\underline{S}}_{\mathrm{Re}f(P1)}$$

$$\underline{\underline{S}}_{\mathrm{Re}f(P1)} = \begin{bmatrix} S_{11} & 0 \\ 0 & 0 \end{bmatrix}$$

$$\underline{\underline{S}}_{(P1,r,T)} = \sqrt{\frac{\underline{\underline{S}}_{Track(P1)}}{\underline{\underline{S}}_{\mathrm{Re}f(P1)}}}$$

b) $$\underline{\underline{S}}_{(P1,r,T)}^{-1} = \begin{bmatrix} 0 & \dfrac{1}{\underline{\underline{S}}_{(P1,r,T)}} \\ \dfrac{1}{\underline{\underline{S}}_{(P1,r,T)}} & 0 \end{bmatrix}$$

c) $$\underline{\underline{S}}_{Track(P2)} = \underline{\underline{S}}_{(P2,r,T)}^2 \cdot \underline{\underline{S}}_{\mathrm{Re}f(P2)}$$

$$\underline{\underline{S}}_{\mathrm{Re}f(P2)} = \begin{bmatrix} 0 & 0 \\ 0 & S_{22} \end{bmatrix}$$

$$\underline{\underline{S}}_{(P2,r,T)} = \sqrt{\frac{\underline{\underline{S}}_{Track(P2)}}{\underline{\underline{S}}_{\mathrm{Re}f(P2)}}}$$

d) $$\underline{\underline{S}}_{(P2,r,T)}^{-1} = \begin{bmatrix} 0 & \dfrac{1}{\underline{\underline{S}}_{(P2,r,T)}} \\ \dfrac{1}{\underline{\underline{S}}_{(P2,r,T)}} & 0 \end{bmatrix}$$

# EP 2 743 719 A1

Europäisches Patentamt

European Patent Office

Office européen des brevets

## EUROPÄISCHER RECHERCHENBERICHT

Nummer der Anmeldung

EP 13 00 5631

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 2 081 031 A1 (COM DEV INT LTD [CA]) 22. Juli 2009 (2009-07-22) * Zusammenfassung; Abbildungen 1-8 * * Absätze [0006], [0025] - Absatz [0160] * | 1-8 | INV. G01R35/00 |
| A | US 2009/072846 A1 (FJERSTAD WAYNE H [US]) 19. März 2009 (2009-03-19) * Absatz [0017] - Absatz [0024]; Abbildungen 1,2C,3 * | 1-8 | |
| A | US 2002/011856 A1 (HUANG GUANGHUA [US] ET AL) 31. Januar 2002 (2002-01-31) * Absatz [0037] - Absatz [0039]; Abbildung 8 * | 1-8 | |
| A,D | "Application Note 1364-1 Agilent De-embedding and Embedding S-Parameter Networks Using a Vector Network Analyzer", , 30. Mai 2004 (2004-05-30), XP055106311, Gefunden im Internet: URL:http://cp.literature.agilent.com/litweb/pdf/5980-2784EN.pdf [gefunden am 2014-03-07] * das ganze Dokument * | 1-8 | RECHERCHIERTE SACHGEBIETE (IPC) G01R |

Der vorliegende Recherchenbericht wurde für alle Patentansprüche erstellt

| Recherchenort | Abschlußdatum der Recherche | Prüfer |
|---|---|---|
| Berlin | 7. März 2014 | Ernst, Monika |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 13 00 5631

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

07-03-2014

| Im Recherchenbericht angeführtes Patentdokument | Datum der Veröffentlichung | Mitglied(er) der Patentfamilie | Datum der Veröffentlichung |
|---|---|---|---|
| EP 2081031 A1 | 22-07-2009 | AT 481647 T<br>CA 2650359 A1<br>EP 2081031 A1<br>ES 2353049 T3<br>US 2009184721 A1 | 15-10-2010<br>17-07-2009<br>22-07-2009<br>24-02-2011<br>23-07-2009 |
| US 2009072846 A1 | 19-03-2009 | KEINE | |
| US 2002011856 A1 | 31-01-2002 | AT 491159 T<br>AU 8086901 A<br>CN 1449498 A<br>EP 1307751 A2<br>JP 2004505281 A<br>KR 20030029797 A<br>TW 557446 B<br>US 2002011856 A1<br>WO 0210783 A2 | 15-12-2010<br>13-02-2002<br>15-10-2003<br>07-05-2003<br>19-02-2004<br>16-04-2003<br>11-10-2003<br>31-01-2002<br>07-02-2002 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- US 6249128 B1

**In der Beschreibung aufgeführte Nicht-Patentliteratur**

- Measuring Non-insertable Devices. *Agilent Technologies,* August 1988

- De-embedding and Embedding S-Parameter Networks Using a Vector Network Analyzer. *Agilent Technologies,* 30. Mai 2004